(19) **Europäisches Patentamt / European Patent Office / Office européen des brevets**

(11) **EP 4 411 545 B1**

(12) # EUROPEAN PATENT SPECIFICATION

(45) Date of publication and mention
of the grant of the patent:
**19.11.2025 Bulletin 2025/47**

(21) Application number: **22880149.4**

(22) Date of filing: **27.09.2022**

(51) International Patent Classification (IPC):
*G11C 29/44* (2006.01)    *G11C 29/02* (2006.01)
*G11C 29/10* (2006.01)    *G11C 29/16* (2006.01)
*G11C 29/52* (2006.01)    *G06N 20/10* (2019.01)
*G06F 11/10* (2006.01)    *G06F 11/00* (2006.01)
*G06F 11/07* (2006.01)    *G06F 11/30* (2006.01)
*G06F 11/34* (2006.01)    *G11C 7/10* (2006.01)
*G11C 11/54* (2006.01)    *G11C 29/04* (2006.01)
*G11C 29/42* (2006.01)

(52) Cooperative Patent Classification (CPC):
**G06N 20/10; G06F 11/008; G06F 11/073;
G06F 11/10; G06F 11/3037; G06F 11/3058;
G06F 11/3476; G11C 29/028; G11C 29/10;
G11C 29/16; G11C 29/44; G11C 29/52;**
G11C 7/1012; G11C 11/54; G11C 29/42;    (Cont.)

(86) International application number:
**PCT/CN2022/121694**

(87) International publication number:
**WO 2023/061209 (20.04.2023 Gazette 2023/16)**

(54) **METHOD FOR PREDICTING MEMORY FAULT, AND ELECTRONIC DEVICE AND COMPUTER-READABLE STORAGE MEDIUM**

VERFAHREN ZUR VORHERSAGE VON SPEICHERFEHLERN SOWIE ELEKTRONISCHE VORRICHTUNG UND COMPUTERLESBARES SPEICHERMEDIUM

PROCÉDÉ DE PRÉDICTION D'ANOMALIE DE MÉMOIRE, ET DISPOSITIF ÉLECTRONIQUE ET SUPPORT DE STOCKAGE LISIBLE PAR ORDINATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.10.2021 CN 202111189254**

(43) Date of publication of application:
**07.08.2024 Bulletin 2024/32**

(73) Proprietor: **ZTE Corporation**
**Shenzhen, Guangdong 518057 (CN)**

(72) Inventors:
• **YI, Zhe**
**Shenzhen, Guangdong 518057 (CN)**
• **HUANG, Jingfeng**
**Shenzhen, Guangdong 518057 (CN)**
• **ZHENG, Ziyang**
**Shenzhen, Guangdong 518057 (CN)**
• **CHEN, Xiaoyan**
**Shenzhen, Guangdong 518057 (CN)**

(74) Representative: **Canzler & Bergmeier Patentanwälte Partnerschaft mbB Despag-Straße 6 85055 Ingolstadt (DE)**

(56) References cited:
WO-A1-2016/188175    CN-A- 110 598 802
CN-A- 112 579 327    CN-A- 113 297 046
CN-A- 113 297 046    US-A1- 2015 067 410
US-A1- 2015 074 469

EP 4 411 545 B1

(52) Cooperative Patent Classification (CPC): (Cont.)
G11C 2029/0409; G11C 2029/0411;
G11C 2029/4402; Y02D 10/00

## Description

TECHNICAL FIELD

The present application relates to, but is not limited to, the technical field of big data analytics and artificial intelligence.

BACKGROUND

In the application field of big data such as a server, unexpected memory faults (or failures) cause frequent downtime of the computer, and even causes service interruption of the server in a serious condition. Therefore, real-time failure prediction and health degree assessment on the memory have important practical significance for maintaining service reliability and stability.

Current perception of memory failure risks in the industry depends on simple summation of the reported memory logs, i.e.: reporting and alarming a network manager when the number of times of error checking and correcting (ECC) reaches a set threshold. However, the number of times of ECC is not very highly correlated with the memory failure in practice, and predicting a memory failure purely by counting the ECC leads to a very low accuracy. Chinese patent application publication No. CN 113297046 A discloses an early warning method and device for a memory fault, relates to the technical field of computers, and mainly aims to describe features corresponding to a memory working state from multiple dimensions so as to predict whether the memory has a fault risk or not. U.S. patent application publication No. 2015074469 A1 provides a method for providing notification of a predictable memory failure including the steps of: obtaining information regarding at least one condition associated with a memory; calculating a memory failure probability as a function of the obtained information; calculating a failure probability threshold; and generating a signal when the memory failure probability exceeds the failure probability threshold, the signal being indicative of a predicted future memory failure.

SUMMARY

The features of the method for predicting a memory failure for a memory under test, the device and the computer-readable storage medium according to the present invention are defined in the independent claims, and the preferable features according to the present invention are defined in the dependent claims. The present application provides a method for predicting a memory failure, including: acquiring multiple types of log data of a memory under test, wherein the multiple types of log data include at least: memory error information address data; performing feature engineering construction according to the multiple types of log data, to obtain respective feature data tables corresponding to the multiple types of log data; splicing the respective feature data tables corresponding to the multiple types of log data, to obtain a spliced feature data table; and obtaining a failure prediction result of the memory under test according to the spliced feature data table and a pre-trained failure prediction model, wherein the failure prediction model is obtained by training with a pre-collected training data set, and samples in the training data set include multiple types of log data of multiple types of memories.

The present application further provides an electronic device, including: at least one processor; and a memory in communicative connection with the at least one processor; wherein the memory stores instructions executable by the at least one processor thereon which, when executed by the at least one processor, cause the at least one processor to implement any method for predicting a memory failure as described herein.

The present application further provides a computer-readable storage medium having a computer program stored thereon which, when executed by a processor, causes the processor to implement any method for predicting a memory failure as described herein.

BRIEF DESCRIPTION OF DRAWINGS

FIG. 1 is a flowchart of a method for predicting a memory failure according to the present application;
FIG. 2 is an architecture diagram of a memory under test according to the present application;
FIG. 3 is a schematic diagram of acquiring multiple types of log data according to the present application;
FIG. 4 is a flowchart of data pre-processing according to the present application;
FIG. 5 is a flowchart of acquiring a feature data table corresponding to memory error information address data according to the present application;
FIG. 6 is a flowchart of training a failure prediction model according to the present application;

FIG. 7 is a schematic diagram of labeling according to a binary classification method and a regression method of the present application; and

FIG. 8 is a block diagram of an electronic device according to the present application.

## DETAIL DESCRIPTION OF EMBODIMENTS

To make the objects, technical solutions and advantages of the implementations of the present application clearer, implementations of the present application will be described in detail below with reference to the accompanying drawings. However, it will be appreciated by those of ordinary skill in the art that numerous technical details are set forth in various implementations of the present application to provide a better understanding of the present application. However, the technical solutions claimed in the present application can be implemented even without these technical details or based on various changes and modifications based on the following implementations. The following implementations are divided for convenience of description, and should not constitute any limitation to the specific implementation of the present application, and the implementations may be mutually incorporated and referred to without contradiction.

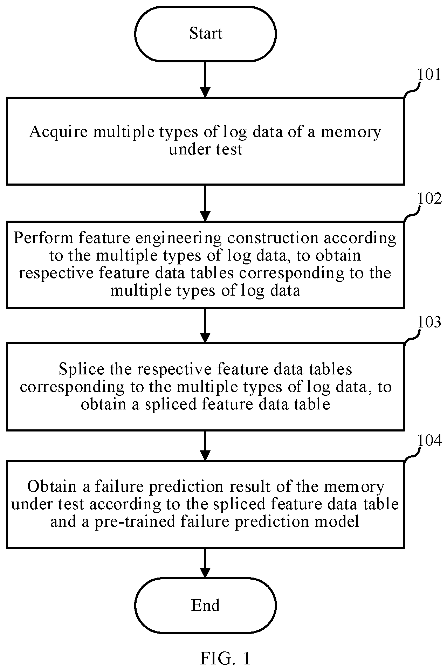

An implementation of the present application relates to a method for predicting a memory failure applied to an electronic device. The electronic device may be a server for performing failure prediction (referred to as a prediction server). For example, a device under test for memory failure prediction collects its own data and sends the same to the prediction server, and then the prediction server performs memory failure prediction on the device under test. The device under test may be a server, a big data center cluster, a communication base station, a personal computer (PC), or any other device including a memory. In this implementation, a flowchart of the method for predicting a memory failure may be as shown in FIG. 1, and includes the following operations 101 to 104.

At operation 101: acquiring multiple types of log data of a memory under test. The multiple types of log data include at least: memory error information address data.

At operation 102: performing feature engineering construction according to the multiple types of log data, to obtain respective feature data tables corresponding to the multiple types of log data.

At operation 103: splicing the respective feature data tables corresponding to the multiple types of log data, to obtain a spliced feature data table.

At operation 104: obtaining a failure prediction result of the memory under test according to the spliced feature data table and a pre-trained failure prediction model. The failure prediction model is obtained by training with a pre-collected training data set, and samples in the training data set include multiple types of log data of multiple types of memories.

In this implementation, since multiple types of log data of the memory under test are acquired, and the multiple types of log data include at least memory error information address data, the multiple types of log data can be used for assessing a state of the memory under test from various aspects, and thereby provide a more comprehensive reference for failure prediction and improve the accuracy of failure prediction. Further, since the multiple types of log data include at least memory error information address data, necessary reference information is ensured to be provided for failure prediction. Since feature engineering construction is performed on the multiple types of log data respectively, and respective feature data tables corresponding to the multiple types of log data after the feature engineering construction are spliced, a spliced feature data table suitable for input of the failure prediction model can be obtained, and therefore, a failure prediction result of the memory under test can be obtained according to the spliced feature data table and a pre-trained failure prediction model. Since samples in the training data set of the failure prediction model include multiple types of log data of multiple types of memories, the failure prediction model has better generalization capability and stability, and the prediction result obtained from the failure prediction model is more accurate, namely, the accuracy of memory failure prediction is improved.

Exemplary description of implementation details of the method for predicting a memory failure according to this implementation is given below, and the following description is provided merely for facilitating understanding of the implementation details and is not necessary for implementing the present solution.

In operation 101, a device under test (e.g., a server) where the memory under test is located may acquire multiple types of log data from the memory under test, and send the multiple types of log data to the prediction server, so that the prediction server can acquire the multiple types of log data of the memory under test. The multiple types of log data include at least: memory error information address data, so as to ensure necessary reference information provided for memory failure prediction.

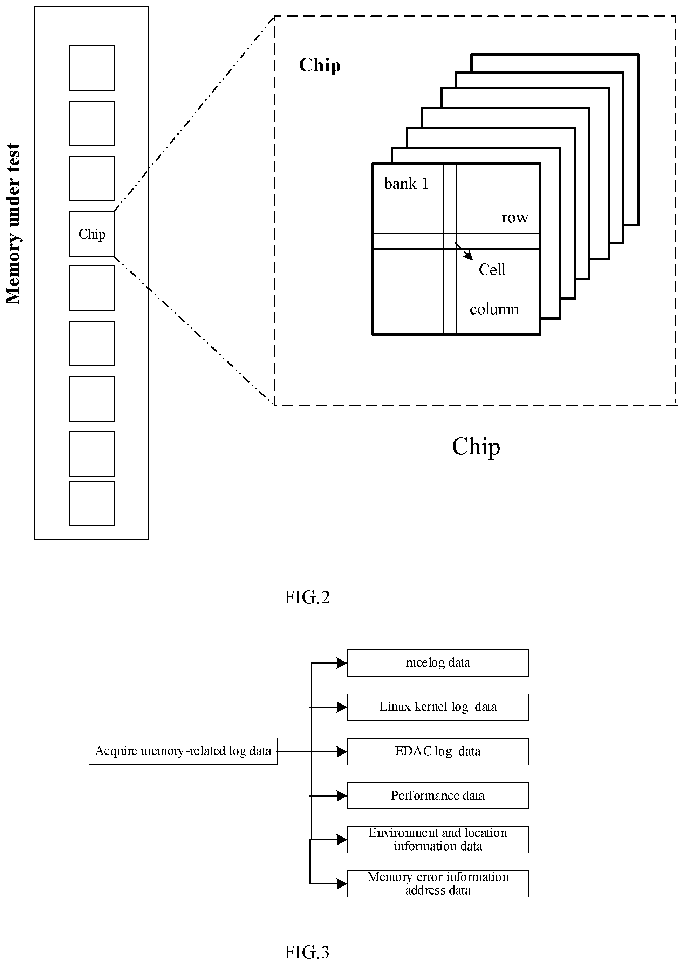

An architecture diagram of the memory under test is as shown in FIG. 2, where the left side of FIG. 2 shows a schematic diagram of a plurality of chips in the memory under test, the right side of FIG. 2 shows a schematic diagram of one chip in the memory under test. One chip is physically divided into 8 layers each being a bank. For example, bank 1 in FIG. 2 may indicate a first bank in the chip, row represents a row in bank 1, column represents a column in bank 1, and the row and the column meet at an intersection, which is a cell.

The acquired memory error information address data includes: a memory serial number, a memory manufacturer, log reporting time, a dual inline memory module (DIMM) of memory, a rank number of memory, a chip number of memory, bank information of memory, a row number of cell, and a column number of cell. The memory error information address data may further include a detailed physical location of the memory failure analyzed from the memory failure logs.

In an implementation, in addition to the memory error information address data, the acquired multiple types of log data further include any one or combination of: memory log data, operating system kernel logs, error detection and correction (EDAC) logs, performance data, or environment and location information data.

The memory log data includes: a register set number field, a transaction field, a memory serial number, a memory manufacturer, and log reporting time.

In an example, the memory log data is dynamic random access memory (DRAM) failure logs reported by mcelog collected by an mcelog tool, where the mcelog tool is a standard tool for recording DRAM failures based on an Intel machine check architecture (MCA) in the Linux system. In other words, the memory log data may be mcelog data.

In an example, the operating system kernel logs may record information related to the memory failure obtained from Linux kernel logs. The operating system kernel logs include: a memory serial number, a memory manufacturer, log reporting time, and various types of fields related to memory errors.

In an example, the error detection and correction (EDAC) logs include: a memory serial number, log reporting time, a memory controller (MC) field, a page field, and an offset field. EDAC and ECC are both error detection and correction, where ECC is error detection and correction on memory hardware; and EDAC is error detection and correction on software inside a Linux kernel.

In an example, the performance data records physical performance data related to the server where the memory under test is located, including: a number of times of transferring data from a magnetic disk to a memory per second, i.e., page in, a number of times of transferring data from a memory to a magnetic disk per second, i.e., page out, a minimum voltage, a maximum voltage, a configuration voltage, and a memory operating speed.

In an example, the environment and location information data records environment and location information of a server where the memory under test is located, including: a temperature, a humidity, a site of the server where the memory under test is located, a room of the server where the memory under test is located, and a rack of the server where the memory under test is located.

In this implementation, it has been found in researches that the memory log data, the operating system kernel logs, the EDAC logs, the performance data, the environment and location information data all have important influences on memory failures, and the addition of these types of data can improve the stability of the generalization capability of the failure prediction model, and is beneficial to improving the accuracy of failure prediction.

In an implementation, when operation 101 is implemented, the server where the memory under test is located may acquire six types of log data in the memory under test at the same time, which, as shown in FIG. 3, include: mcelog data, Linux kernel log data, EDAC log data, performance data, environment and location information data, and memory error information address data.

In operation 102, before performing feature engineering construction according to the multiple types of log data, to obtain respective feature data tables corresponding to the multiple types of log data, the prediction server may perform pre-processing on the acquired multiple types of log data in the memory under test, where the pre-processing may include: filling an average value or 0 in a field, which is not acquired, in the multiple types of log data; discarding fields irrelevant to the memory failure; and if some columns of fields in the multiple types of log data have strong correlation, keeping only one column of the fields while deleting the other column(s) of the fields.

In an example, the pre-processed multiple types of log data may be further subjected to data check including, for example: checking whether a time length of data and the number of sampling points meet a minimum condition requirement of failure prediction or of a data amount desired by failure prediction, that is, whether the data collection time meets a time length desired by feature engineering construction, and whether the collected multiple types of log data includes at least memory error information address data.

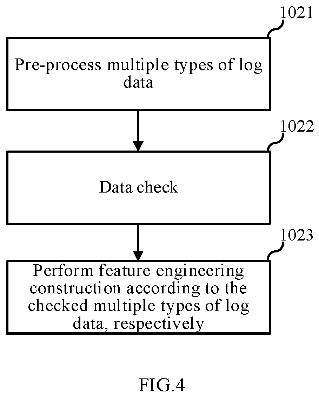

In an implementation, the operation 102 of processing and performing feature engineering construction on the multiple types of log data to obtain the feature data tables corresponding to the multiple types of log data may be implemented by the following sub-operations 1021 to 1023 as shown in the exemplary flow of FIG. 4.

At sub-operation 1021, pre-processing multiple types of log data.

The pre-processing may include: filling a null value with "0"; and analyzing the collected multiple types of log data by a Pearson correlation coefficient, deleting columns with strong correlation among fields and columns with the same data or with 0 only, and discarding fields irrelevant to the memory failure.

At sub-operation 1022, checking data.

The sub-operation of checking data may include: checking a time length and the number of sampling points of the pre-processed multiple types of log data. It is checked whether a time length of the data and the number of sampling points meet a minimum condition requirement on the data amount for failure detection and prediction, that is, whether the data collection time meets a time length desired by feature engineering construction, and whether the multiple types of log data includes at least memory error information address data.

At sub-operation 1023, performing feature engineering construction according to the checked multiple types of log data, respectively.

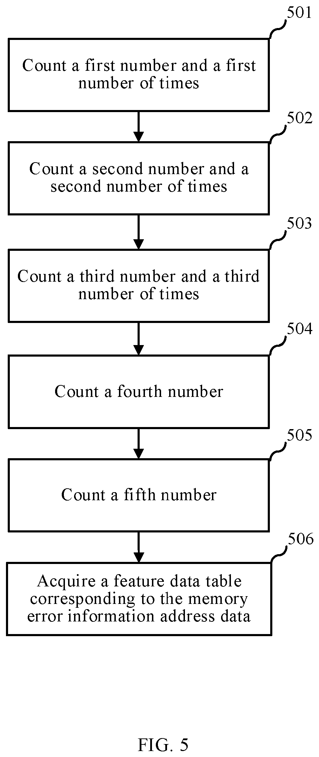

In an implementation, the prediction server performs feature construction according to the pre-processed memory error information address data, to obtain a feature data table corresponding to the memory error information address data. Referring to FIG. 5, the obtaining the feature data table corresponding to the memory error information address data includes operations 501 to 506.

At operation 501: counting a first number and a first number of times. The prediction server counts, according to the memory error information address data, a first number of first targets appearing in a first preset time period before a current time point, and a first number of times of ECC appearing on each first target. Each of the first targets is a cell, among cells in the memory under test, on which ECC appears 2 times or more in a past second preset time period, and the second preset time period has a duration longer than the first preset time period.

At operation 502: counting a second number and a second number of times. The prediction server counts, according to the memory error information address data, a second number of second targets appearing in a third preset time period before the current time point, and a second number of times of ECC appearing on each second target. Each of the second targets is a column of cells, among columns of cells in the memory under test, on which ECC appears 2 times or more in total at the same time point in a past fourth preset time period, and the fourth preset time period has a duration longer than the third preset time period. The same time point may refer to the same second or the same minute.

At operation 503: counting a third number and a third number of times. The prediction server counts, according to the memory error information address data, a third number of third targets appearing in a fifth preset time period before the current time point, and a third number of times of ECC appearing on each third target. Each of the third targets is a row of cells, among rows of cells in the memory under test, on which ECC appears 2 times or more in total at the same time point in a past sixth preset time period, and the sixth preset time period has a duration longer than the fifth preset time period.

At operation 504: counting a fourth number. The prediction server counts, according to the memory error information address data, a fourth number of fourth targets appearing in a seventh preset time period before the current time point. Each of the fourth targets is a cell block consisting of at least three cells in the same column in the memory under test, the at least three cells in the same column have ECC at the same time point in a past eighth preset time period and are separated from each other by one cell at most, and the eighth preset time period has a duration longer than the seventh preset time period.

At operation 505: counting a fifth number. The prediction server counts, according to the memory error information address data, a fifth number of fifth targets appearing in a ninth preset time period before the current time point. Each of the fifth targets is a cell block consisting of at least three cells in the same row in the memory under test, the at least three cells in the same row have ECC at the same time point in a past tenth preset time period and are separated from each other by one cell at most, and the tenth preset time period has a duration longer than the ninth preset time period.

At operation 506: acquiring a feature data table corresponding to the memory error information address data.

The feature data tables corresponding to the memory error information address data is obtained according to any one or combination of: the first number, the first number of times, the second number, the second number of times, the third number, the third number of times, the fourth number, or the fifth number.

In operation 501, the first preset time period is a time period before the current time point, the first target may be recorded as ERROR CELL, the first number is the number of first targets ERROR CELLs appearing in the first preset time period before the current time point, the first number of times is a total number of times of ECC occurring on each ERROR CELL in the first preset time period before the current time point, and the second preset time period is a time length of collecting memory error information address data desired for construction of the first target.

In an example, the second preset time period may be 3 months, and for convenience of data splicing and alignment, the first preset time period may be a time period on the granularity of complete minutes before the current time point. In some examples, the first preset time period may be 8min, 4min, 2min, or lmin before the current time point. That is, the total number of times (i.e., the first number of times) of ECC appearing on each ERROR CELL and the number (i.e., the first number) of ERROR CELLs corresponding to the ECC are counted within 8min, 4min, 2min, or lmin before the current time point, respectively.

In operation 502, the second target may be recorded as ERROR COLUMN, the second number is the number of second targets ERROR COLUMNs appearing in the third preset time period before the current time point, the second number of times is a total number of times of ECC occurring on each ERROR COLUMN in the third preset time period before the current time point, and the fourth preset time period is a time length of collecting memory error information address data desired for construction of the second target.

In an example, the fourth preset time period may be 3 months, and the third preset time period may be 8min, 4min, 2min, or lmin before the current time point. That is, the total number of times (i.e., the second number of times) of ECC appearing on each ERROR COLUMN and the number (i.e., the second number) of ERROR COLUMNs corresponding to the ECC are counted within 8min, 4min, 2min, or lmin before the current time point, respectively.

In operation 503, the third target may be recorded as ERROR ROW, the third number is the number of third targets ERROR ROWs appearing in the fifth preset time period before the current time point, the third number of times is a total number of times of ECC occurring on each ERROR ROW in the fifth preset time period before the current time point, and the sixth preset time period is a time length of collecting memory error information address data desired for construction of the third target.

In an example, the sixth preset time period may be 3 months, and the fifth preset time period may be 8min, 4min, 2min, or Imin before the current time point. That is, the total number of times (i.e., the third number of times) of ECC appearing on each ERROR ROW and the number (i.e., the third number) of ERROR CELLS corresponding to the ECC are counted within 8min, 4min, 2min, or Imin before the current time point, respectively.

In operation 504, the fourth target may be recorded as ERROR COL BLOCK, the fourth number is the number of fourth targets ERROR COL BLOCKs appearing in the seventh preset time period before the current time point, and the eighth preset time period is a time length of collecting memory error information address data desired for construction of the fourth target.

In an example, the eighth preset time period may be 3 months. For example, if three of five consecutive cells in the same column have ECC at the same time point, that is, the 1st, 3rd, and 5th cells of the five cells have ECC, the five cells form an ERROR COL BLOCK. Alternatively, if three consecutive cells in the same column all have ECC at the same time point, the three cells form an ERROR COL BLOCK. The seventh preset time period may be 8min, 4min, 2min, or Imin before the current time point. That is, the number (i.e., the fourth number) of ERROR COL BLOCKs is counted within 8min, 4min, 2min, or Imin before the current time point, respectively. The same time point may refer to the same second or the same minute.

In operation 505, the fifth target may be recorded as ERROR ROW BLOCK, the fifth number is the number of fifth targets ERROR ROW BLOCKs appearing in the ninth preset time period before the current time point, and the tenth preset time period is a time length of collecting memory error information address data desired for construction of the fifth target.

In an example, the tenth preset time period may be 3 months. For example, if three of five consecutive cells in the same row have ECC at the same time point, that is, the 1st, 3rd, and 5th cells of the five cells have ECC, the five consecutive cells form an ERROR ROW BLOCK. Alternatively, if three consecutive cells in the same row all have ECC at the same time, the three cells form an ERROR ROW BLOCK. The ninth preset time period may be 8min, 4min, 2min, or Imin before the current time point. That is, the number (i.e., the fifth number) of ERROR ROW BLOCKs is counted within 8min, 4min, 2min, or Imin before the current time point, respectively.

It should be noted that in the above operations, the first, third, fifth, seventh, and ninth preset time periods may be the same or different, and the second, fourth, sixth, eighth, and tenth preset time periods may be the same or different.

In this implementation, since the memory failure is communicable on columns and rows of the memory, by constructing concepts related to memory defects such as the first target ERROR CELL, the second target ERROR COLUMN, the third target ERROR ROW, the fourth target ERROR COLUMN BLOCK, the fifth target ERROR ROW BLOCK, and the like, and counting the related numbers and numbers of times, it is beneficial to accurately measuring the memory failure and improving the accuracy of memory failure prediction.

In an implementation, the prediction server performs feature construction according to the multiple types of log data, to obtain respective feature data tables corresponding to the multiple types of log data. In addition to the memory error information address data, the multiple types of log data further include any one or combination of: memory log data, operating system kernel logs, error detection and correction (EDAC) logs, performance data, or environment and location information data. By means of the refined processing of the memory log data, the operating system kernel logs, the error detection and correction (EDAC) logs, the performance data, the environment and location information data and the like, a feature data table corresponding to each type of log data is obtained, which is beneficial to improving the accuracy of failure prediction. The following gives an exemplary description of acquiring the respective feature data tables corresponding to the multiple types of log data.

In an example, under the condition that the multiple types of log data further include the memory log data, transaction fields in an eleventh preset time period before the current time point are summed according to the memory log data, to obtain a summation result of the transaction fields, and register set number fields in the eleventh preset time period before the current time point are counted, to obtain a count result of the register set number fields, and then, a feature data table corresponding to the memory log data is obtained according to the summation result of the transaction fields and the count result of the register set number fields.

In an example, the register set number field may be an mca_bank field, and the eleventh preset time period may be 8min, 4min, 2min, or 1min. In other words, the prediction server may count the mca_bank fields within 8min, 4min, 2min, or Imin before the current time point and sum the transaction fields, so as to form a new feature column, where the new feature column is a feature column in the feature data table corresponding to the memory log data.

For example, given that the current time is 10:27, the data within 1min before the current time point is data collected within a time period from 10:26 to 10:27, and then the mca_bank fields collected within the time period from 10:26 to 10:27 are counted, and the transaction fields within this time period are summed; data within 2min before the current time point is data collected within a time period from 10:25 to 10:27; the data within 4min before the current time point is data collected within a time period from 10:23 to 10:27; and data within 8min before the current time point is data collected within a time period from 10: 19 to 10:27.

In an exemplary implementation, since the register set number field is a register set number of a string data type captured from the memory by an mcelog tool, the counting can be performed. Meanwhile, since the transaction field is a set of operations of an integer data type transmitted between the CPU and the memory, including read and write transactions, summing the transaction fields can better reflect data features of the fields, while pure counting thereon may discard data information in the transaction fields, and therefore, the transaction fields are summed.

In an example, under the condition that the multiple types of log data further include the operating system kernel logs, various types of fields related to memory errors in the operating system kernel logs are counted, the various types of fields are counted in a twelfth preset time period before the current time point, to obtain respective count results corresponding to the various types of fields, and then, a feature data table corresponding to the operating system kernel logs is obtained according to the respective count results corresponding to the various types of fields.

The various types of fields related to memory errors may be counted in the twelfth preset time period based on the granularity of complete minutes. For example, the twelfth preset time period is 8min, 4min, 2min, or 1min, that is, the prediction server may count various types of fields related to memory errors within 8min, 4min, 2min, or 1min before the current time point to form a new feature column, where the new feature column is a feature column in the feature data table corresponding to the operating system kernel logs.

In an exemplary implementation, since there are 24 types of fields in the operating system kernel logs, 8 of which are related to memory errors, only the 8 types of fields related to memory errors are counted in the twelfth preset time period before the current time point, to obtain count results of the 8 types of fields related to memory errors, and then, according to the count results corresponding to the 8 types of fields related to memory errors, a feature data table corresponding to the operating system kernel logs is obtained.

In an example, under the condition that the multiple types of log data further include the EDAC logs, MC fields, page fields and offset fields in a thirteenth preset time period before the current time point are counted according to the EDAC logs, to obtain a count result of the MC fields, a count result of the page fields, and a count result of the offset fields, and then a feature data table corresponding to the EDAC logs is obtained according to the count result of the MC fields, the count result of the page fields, and the count result of the offset fields. The MC field represents a serial number of a memory controller, page represents a page of a virtual memory, offset represents an offset, and page+offset can be used to calculate a physical address of the memory.

The fields (MC, page and offset) in the thirteenth preset time period may be counted based on the granularity of complete minutes. For example, the thirteenth preset time period is 8min, 4min, 2min, or 1min, which means that the prediction server may count the fields (MC, page and offset) within 8min, 4min, 2min, or 1min before the current time point to form a new feature column. The new feature column is a feature column in the feature data table corresponding to the EDAC logs.

In an example, under the condition that the multiple types of log data further include the performance data, various types of performance data influencing the memory failure in a fourteenth preset time period before the current time point are averaged according to the performance data, to obtain an average value of the various types of performance data, and a feature data table corresponding to the performance data is obtained according to the average value of the various types of performance data.

The fields (page_in, page_out, minimum voltage, maximum voltage, configuration voltage, and memory operating speed) in the fourteenth preset time period may be counted based on the granularity of complete minutes. For example, the fourteenth preset time period is 8min, 4min, 2min, or 1min, which means that the prediction server may average the fields related to performance data within 8min, 4min, 2min, or 1min before the current time point to form a new feature column.

In an exemplary implementation, page_in, page_out, minimum voltages, maximum voltages, configuration voltages, and memory operating speeds in the fourteenth preset time period before the current time point are averaged to obtain average values of the page_in, the page_out, the minimum voltages, the maximum voltages, the configuration voltages, and the memory operating speeds, respectively, and then, a feature data table corresponding to the performance data is obtained according to the average values.

In an example, under the condition that the multiple types of log data further include the environment and location information data, temperatures and humidities in a fifteenth preset time period before the current time point are averaged according to the environment and location information data, to obtain an average value of the temperatures and an average value of the humidities, and a feature data table corresponding to the environment and location information data is obtained according to the average value of the temperatures and the average value of the humidities.

The fields (e.g., temperature and humidity) in the fifteenth preset time period may be counted based on the granularity of complete minutes. For example, the fifteenth preset time period is 8min, 4min, 2min, or 1min, which means that the prediction server may average the fields related to environmental data, such as temperature, humidity and the like, within 8min, 4min, 2min, or 1min before the current time point to form a new feature column, where the new feature column is a feature column in the feature data table corresponding to the environment and location information data. Then, the memory under test is matched with location information, such as site, room, rack and the like, of the server where the memory is located.

It should be noted that in specific implementations, the eleventh, twelfth, thirteenth, fourteenth and fifteenth preset time periods may be the same or different, which is not specifically limited in the implementation.

In an implementation, in operation 101, the prediction server may acquire multiple types of log data of a memory under test on the granularity of complete minutes, and in operation 102, performing feature engineering construction may include: combining, when multiple types of log data within m minutes closest to the current time point are acquired, the multiple types of log data within the m minutes with multiple types of log data within n minutes before the m minutes, and taking the combined multiple types of log data as the log data desired for failure prediction at the current time point, where n+m minutes represents a preset shortest time length for failure prediction; and performing feature engineering construction on the granularity of minutes according to the log data desired for the failure prediction at the current time point, to obtain respective feature data tables corresponding to the multiple types of log data. For example, m can take a value of 1, 10, 0.1, or the like. Acquiring the log data on the granularity of minutes can facilitate minute-level prediction and real-time monitoring on the memory state, thereby improving the real-time performance of memory failure prediction.

In an example, m is 1, and n is 7, and exemplarily, if multiple types of log data within 1 minute closest to the current time point are acquired, while multiple types of log data of at least 8 minutes are desired for failure prediction, that is, the preset shortest time length for failure prediction is 8 minutes, then at a 9th minute, the multiple types of log data acquired in the 9th minute are combined with the multiple types of log data acquired in the previous 7 minutes to be used as the multiple types of log data for failure prediction at the 9th minute. For example, given that the current time is 10:27, if multiple types of log data within 1 minute before 10:27, i.e., from 10:26 to 10:27, are acquired, while multiple types of log data acquired within 8 minutes, i.e., from 10:19 to 10:27, are required for failure prediction, then the multiple types of log data acquired within this 1 minute, i.e., from 10:26 to 10:27 is combined with the multiple types of log data acquired in the previous 7 minutes, i.e., from 10:19 to 10: 26, to form the combined 8-minute data used as the multiple types of log data for failure prediction at 10:27.

In operation 103, feature construction is performed on the multiple types of log data of the memory under test, to obtain the respective feature data tables, and a feature data table corresponding to memory error information address data is spliced with any one or combination of the following feature data tables according to the memory serial number based on the granularity of complete minutes: a feature data table corresponding to memory log data, a feature data table corresponding to operating system kernel logs, a feature data table corresponding to performance data, or a feature data table corresponding to environment and location information data, so as to obtain a spliced feature data table.

In operation 104, a server where multiple types of memories are located may collect multiple types of log data of the multiple types of memories in advance, and the prediction server performs feature engineering construction according to the multiple types of log data, to obtain respective feature data tables corresponding to the multiple types of log data, and splices the respective feature data tables corresponding to the multiple types of log data into a spliced feature data table that is used as a sample in a training data set for model training, to obtain a pre-trained failure prediction model. When the failure prediction model is obtained through training, failure prediction can be performed on the memory under test according to the failure prediction model.

In an implementation the failure prediction model is obtained by training with a pre-collected training data set and a LightGBM machine learning method. The LightGBM machine learning method has a loss function FocalLoss, which is expressed as:

$$L_{fl} = \begin{cases} -\alpha \left(1 - y'\right)^{\gamma} \log y' & y = 1 \\ -(1-\alpha) y'^{\gamma} \log\left(1 - y'\right) & y = 0 \end{cases}$$

where $\alpha$ is a balance factor, $\gamma$ is a modulation parameter, y' is a sample predicted value, y is a sample label, and $L_{fl}$ is an error between the sample predicted value and the sample label value.

In an exemplary implementation, since the memory failure prediction may have the problem of unbalanced positive and negative samples, and normal memory data is much more than failed memory data, while the Focal Loss function is a function specially used for processing the problem of unbalanced positive and negative samples. Thus, the Focal Loss function used in establishment of the training model by the LightGBM machine learning method can effectively address the problem of unbalanced positive and negative samples in the training data set for the failure prediction model, thereby ensuring the accuracy of memory failure prediction.

In an implementation, each sample in the training data set is labeled with a label value determined by a binary manner. For example, if a sample at a certain time point is a memory failure sample, each sample within T minutes before this time point is labeled as "1", and each sample before the T minutes is labeled as "0"; where T may take a value from 30 to 100, for example, 90. In other words, although this is a failed memory, it has not reached a risk threshold 90 minutes ago, and thus the data is still considered to be normal. According to the failure prediction model obtained by training with samples labeled in the binary manner, if the output result of the failure prediction model is "1", it indicates that the memory under test may have a failure within the future T minutes; and if the output result of the failure prediction model is " 0", it indicates that the memory under test is normal.

In an implementation, each sample in the training data set is labeled with a label value determined by a regression manner, for example: calculating a time interval between a time point corresponding to each sample and a time point corresponding to a sample with the memory failure; and calculating a label value for each sample according to the time interval and a formula for mapping the time interval into an interval [0, 1]. The formula is:

$$\text{label} = \frac{1}{1+e^{a*(X/T-1)}}$$

where label represents a calculated label value, X is the time interval, a is a first preset coefficient, and T is a preset failure influence duration. Labeling by the regression manner can avoid data loss caused by labeling by the sweeping binary manner, while the label value can reflect a proximity of the data to a failure and thus is more authentic.

In an exemplary implementation, samples in the training data set may use a variant of the sigmiod function to map a time interval to the interval [0, 1], and thus calculate a label value of each sample, and a time point of a failure on the memory under test can be predicted by the sigmiod function, so as to judge a proximity of the label to the time point of the failure. The first preset coefficient a is an empirical value in the range of [1, 10], for example, 8; and X/T takes a value in the range of [0, 1].

After obtaining the output result of the failure prediction model according to the spliced feature data table and the pre-trained failure prediction model, a prediction result of a time point at which the memory under test has the failure is obtained according to the output result and a formula for predicting the time point of the failure.

The formula is:

$$t=b*\ln(\frac{1}{\text{output}}-1)+T$$

where t represents the time point at which the memory under test has the failure, b is a second preset coefficient, output is the output result, and T is a preset failure influence duration. In this manner, not only whether a failure will occur in the future, but also the specific time when the failure occurs, can be predicted, resulting in a higher prediction accuracy.

The output result of the failure prediction model is in the range of [0, 1], and the second preset coefficient is an empirical value in the range of [1, 20], for example, 11.25.

In an example, a*b=T. For example, when a=8 and b=11.25, i.e., a*b=8* 1 1.25=90, the preset failure influence duration T=90.

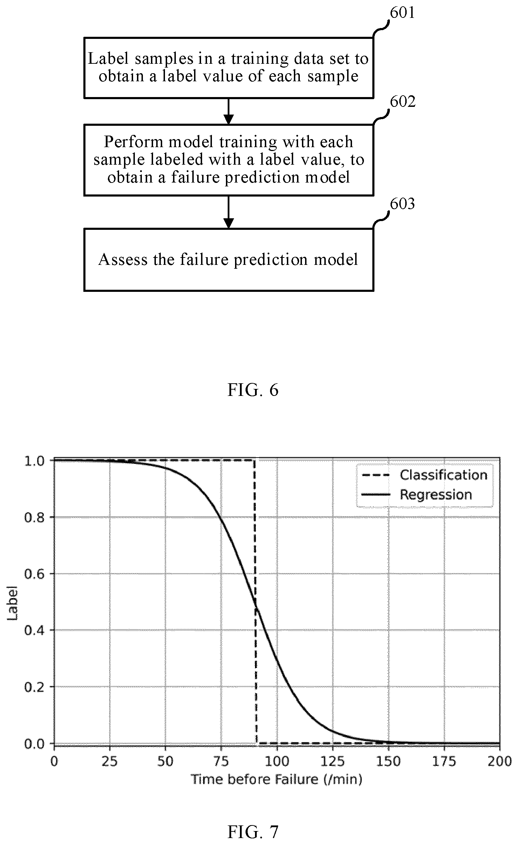

In an implementation, the failure prediction model in operation 104 may be obtained by the method shown in FIG. 6, which includes the following operations 601 to 603.

At operation 601, labeling samples in a training data set to obtain a label value of each sample.

At operation 602, performing model training with each sample labeled with a label value, to obtain a failure prediction model.

At operation 603, assessing the failure prediction model.

The training data set may be formed by the following operations S1 to S3.

At S1: collecting memory related log data (such as the above six types of log data) of different data centers, manufacturers and/or models.

At S2: performing feature engineering construction on the log data, to obtain respective feature data tables corresponding to the multiple types of log data.

At S3: splicing the respective feature data tables corresponding to the multiple types of log data, to obtain a training data set.

In S2, under the condition that the multiple types of log data include memory error information address data, and to acquire a feature data table corresponding to the memory error information address data and use the feature data table as a sample in a training data set for a failure prediction model by the prediction server to establish the failure prediction model, the feature engineering construction may be performed according to the log data of the memory error information address data obtained in S1. The manner of performing feature engineering construction according to the memory error information address data may refer to the manner in FIG. 5, and thus is omitted here to avoid repetition.

In S2, under the condition that the multiple types of log data further include memory log data, operating system kernel logs, performance data, and environment and location information data, and to acquire a feature data table corresponding to the memory log data, a feature data table corresponding to the operating system kernel logs, a feature data table corresponding to the performance data, and a feature data table corresponding to the environment and location information data and use the feature data tables as a sample in a training data set for a failure prediction model by the prediction server to establish the failure prediction model, the feature engineering construction may be performed according to the memory log data, the operating system kernel logs, the error detection and correction (EDAC) logs, the performance data, the environment and location information data, and other types of log data obtained in S1. The manner of performing the feature engineering construction has been described above, and thus is omitted here to avoid repetition.

In an example, the samples in the training data set may be labeled in operation 601 by a binary classification method (i.e., the binary manner mentioned above). Exemplarily, a label-time relational graph of the binary classification is shown as the dotted line (Classification) in FIG. 7, where the abscissa represents a time period before the failure of the memory under test (Time before failure), and the ordinate represents a label value (Label) labeled in the binary classification method. If the preset failure influence duration T is 90 minutes, for the binary classification method, the prediction server will label "1" for all samples in the training data set within the 90 minutes before the failure, and label "0" for samples before 90 minutes ago.

In another example, in operation 601, samples in the training data set may be labeled in a regression manner. Exemplarily, a label-time relational graph of a regression model is shown as the solid line (Regression) in FIG. 7, where the abscissa represents a time period before the failure of the memory under test (Time before failure), and the ordinate represents a label value (Label) labeled in the regression method. If the preset failure influence duration T is 90 minutes, for the regression method, the prediction server will map a time interval to the interval [0, 1] by a variant of the sigmoid function:

$$\text{label} = \frac{1}{1 + e^{8*(X/90-1)}}$$

where label represents a calculated label value, and X is the time interval. For normal memory data, X is $+\infty$, and label is 0.

In an example, in operation 602, LightGBM may be used to train the samples labeled with label values to establish the model, and the Loss function may use a mean square error (MSE) loss function or a Focal Loss function.

In another example, in operation 602, a random forest method may be used to train the samples labeled with label values to establish the model.

In operation 603, 30% of the sample data in the training data set is randomly extracted as a validation set, while the rest sample data is used as a training set.

In an example, the model may use F1_Score as an assessment index, that is, F1_Score is used for assessment on the verification set. Related terms and detailed indexes used in F1_Score are defined as below, where precision represents a precision rate, and recall represents a recall rate:

$n_{pp}$: the number of memories within the assessment window predicted to have a failure in a future time period T;
$n_{tp}$: the number of failed memories within the assessment window found in advance by a time period T; and
$n_{tr}$: the total number of failed memories within the assessment window.

$$\text{precision} = \frac{\text{ntp}}{\text{npp}}$$

$$\text{recall} = \frac{\text{ntp}}{\text{ntr}}$$

$$\text{F1\_Score} = 2 * \frac{\text{precision*recall}}{\text{precision} + \text{recall}}$$

A grid search may be performed on the model-related parameters so that a model score F1 peaks.

In an implementation, the obtaining the failure prediction result of the memory under test according to the spliced feature data table and the pre-trained failure prediction model includes: obtaining a confidence of classifying the memory under test into 1 according to the spliced feature data table and the pre-trained failure prediction model; and determining a health degree of the memory under test according to the confidence; where the health degree is 1-confidence, and the lower the health degree is, the more likely the memory under test has a failure. In other words, if the samples in the training data set are labeled in the binary classification method, an output result of the failure prediction model obtained by the method in FIG. 6 is: confidence (in the range of 0 to 100%) of the machine learning algorithm classifies the memory under test into "1". Therefore, the health degree of the memory under test can be determined according to the confidence, and finally a health degree index is reported to a monitoring center.

In an implementation, the obtaining the failure prediction result of the memory under test according to the spliced feature data table and the pre-trained failure prediction model includes: obtaining a predicted value of the memory under test according to the spliced feature data table and the pre-trained failure prediction model, where the predicted value is a floating-point number between 0 and 1; and determining a health degree of the memory under test according to the predicted value. The health degree is 1-predicted value, and the lower the health degree is, the more likely the memory under test has a failure. In other words, if the samples in the training data set are labeled in the regression method, the prediction server will map a time interval to the interval [0, 1] by a variant of the sigmoid function:

$$label = \frac{1}{1 + e^{8*(X/90-1)}}$$

where label represents a calculated label value, and X is the time interval. For normal memory data, X is $+\infty$, and label is 0. An output result of the failure prediction model obtained by the method in FIG. 6 is: a floating-point number in the range of [0, 1]. Generally, if the output result is greater than 0.5, it represents that a memory failure may occur within the future time T; and otherwise, it indicates that no memory failure will occur in the future time T. The output result is converted into a health degree of 0 to 100%. The output result is a predicted value (in the range of 0 to 1) of performing failure prediction on the memory under test by a machine learning algorithm, and the health degree of the memory under test is 1-predicted value. A lower health degree represents a higher probability of a failure on the memory within the time T, and finally a health degree index is reported to a monitoring center.

In an implementation, if the samples in the training data set are labeled by using the regression method, the failure prediction model obtained by the method in FIG. 6 may have a prediction result being: a time point at which a memory failure will occur. For example, when the failure prediction model is established by using an MSE loss function as the loss function, a time point at which a memory failure will occur may be obtained by:

$$t = 11.25 * \ln\left(\frac{1}{output} - 1\right) + 90$$

Finally, the prediction server may report the calculated time point at which the memory failure will occur to a monitoring center so that the monitoring center performs a corresponding operation.

It should be noted that the above examples in the present implementation are merely for convenience of understanding, and do not form any limitation to the technical solution of the present disclosure.

The division of operations of any of the above methods is merely for clarity, and in implementations, these operations may be combined into one, or a certain operation may be split into a plurality of operations, which both fall into the protection scope of the present disclosure as long as a same logical relationship is included. Any insignificant modification added or any insignificant design introduced to the algorithms or processes without changing core designs of the algorithms or flows falls into the protection scope of the present disclosure.

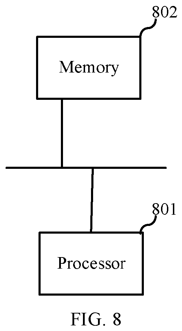

Another implementation of the present disclosure relates to an electronic device which, as shown in FIG. 8, includes at least one processor 801; and a memory 802 in communicative connection with the at least one processor 801. The memory 802 stores instructions executable by the at least one processor 801 thereon which, when executed by the at least one processor 801, cause the at least one processor 801 to perform any method for predicting a memory failure as described above.

The memory 802 and the at least one processor 801 are connected via a bus. The bus may include any number of interconnected buses and bridges, and connect various circuits of the at least one processor 801 and the memory 802 together. The bus may also connect various other circuits such as peripherals, voltage regulators, power management circuits, and the like, which are well known in the art and, therefore, will not be described in further details herein. A bus interface provides an interface between the bus and a transceiver. The transceiver may include one or more elements, such as a plurality of receivers and transmitters, to provide a unit for communicating with various other apparatuses over a transmission medium. Data processed by the processor 801 is transmitted over a wireless medium through an antenna which further receives data and transmits the data to the processor 801.

The processor 801 is responsible for managing the bus and general processing, and may further provide various functions including timing, peripheral interfaces, voltage regulation, power management, and other control functions. The memory 802 may be configured to store data used by the processor 801 during operation.

Another implementation of the present disclosure relates to a computer-readable storage medium with a computer program stored thereon. When the computer program is executed by a processor, the processor is caused to implement any of the above method implementations.

That is, as can be understood by those skilled in the art, all or part of the operations in any of the method implementations described above may be implemented by a program instructing related hardware, where the program is stored in a storage medium and includes several instructions to enable a device (which may be a micro controller unit, a chip, or the like) or a processor to perform all or part of the operations in the method described in any of the above implementations of the present application. The storage medium mentioned before includes: a U disk, a mobile hard disk, a read-only memory (ROM), a random access memory (RAM), a magnetic or optical disk, and other media that can store program codes.

It will be understood by those of ordinary skill in the art that the foregoing implementations are exemplary implementations of the present disclosure, and that, in practical applications, various changes in form and details may be made therein without departing from the scope of the following claims.

**Claims**

1. A method for predicting a memory failure for a memory under test, comprising:

   acquiring (101) multiple types of log data of the memory under test, wherein the multiple types of log data include at least: memory error information address data;
   performing (102) feature engineering construction according to the multiple types of log data, to obtain respective feature data tables corresponding to the multiple types of log data;
   splicing (103) the respective feature data tables corresponding to the multiple types of log data, to obtain a spliced feature data table; and
   obtaining (104) a failure prediction result of the memory under test according to the spliced feature data table and a pre-trained failure prediction model, wherein the failure prediction model is obtained by training with a pre-collected training data set, and samples in the training data set comprise multiple types of log data of multiple types of memories,
   **characterized in that**, the obtaining (104) the failure prediction result of the memory under test according to the spliced feature data table and the pre-trained failure prediction model comprises:

   obtaining an output result of the failure prediction model according to the spliced feature data table and the pre-trained failure prediction model;
   obtaining a prediction result of a time point at which the memory under test has a failure according to the output result and a formula for predicting the time point of the failure;
   wherein the formula is:

   $$t = b*\ln\left(\frac{1}{\text{output}} - 1\right) + T$$

   where t represents the time point at which the memory under test has the failure, b is a second preset coefficient, output is the output result, and T is a preset failure influence duration.

2. The method according to claim 1, wherein the performing (102) feature engineering construction according to the multiple types of log data to obtain respective feature data tables corresponding to the multiple types of log data comprises:

   counting, according to the memory error information address data, a first number of first targets appearing in a first preset time period before a current time point, and a first number of times of error checking and correcting, ECC, appearing on each first target, wherein each of the first targets is a cell, among cells in the memory under test, on which ECC appears 2 times or more in a past second preset time period, and the second preset time period has a duration longer than the first preset time period;
   counting, according to the memory error information address data, a second number of second targets appearing in a third preset time period before the current time point, and a second number of times of ECC appearing on each second target, wherein each of the second targets is a column of cells, among columns of cells in the memory under test, on which ECC appears 2 times or more in total at a same time point in a past fourth preset time period, and the fourth preset time period has a duration longer than the third preset time period;

counting, according to the memory error information address data, a third number of third targets appearing in a fifth preset time period before the current time point, and a third number of times of ECC appearing on each third target, wherein each of the third targets is a row of cells, among rows of cells in the memory under test, on which ECC appears 2 times or more in total at a same time point in a past sixth preset time period, and the sixth preset time period has a duration longer than the fifth preset time period;

counting, according to the memory error information address data, a fourth number of fourth targets appearing in a seventh preset time period before the current time point, wherein each of the fourth targets is a cell block consisting of at least three cells in a same column in the memory under test, the at least three cells in the same column have ECC at a same time point in a past eighth preset time period and are separated from each other by one cell at most, and the eighth preset time period has a duration longer than the seventh preset time period;

counting, according to the memory error information address data, a fifth number of fifth targets appearing in a ninth preset time period before the current time point, wherein each of the fifth targets is a cell block consisting of at least three cells in a same row in the memory under test, the at least three cells in the same row have ECC at a same time point in a past tenth preset time period and are separated from each other by one cell at most, and the tenth preset time period has a duration longer than the ninth preset time period; and

obtaining a feature data table corresponding to the memory error information address data according to any one or any combination of:

the first number, the first number of times, the second number, the second number of times, the third number, the third number of times, the fourth number, or the fifth number.

3. The method according to claim 1 or 2, wherein the multiple types of log data further comprise any one or any combination of:
memory log data, operating system kernel logs, error detection and correction, EDAC, logs, performance data, or environment and location information data.

4. The method according to claim 3, wherein
in a case where the multiple types of log data further comprise the memory log data, the performing (102) feature engineering construction according to the multiple types of log data to obtain respective feature data tables corresponding to the multiple types of log data comprises:

summing, according to the memory log data, transaction fields in an eleventh preset time period before the current time point, to obtain a summation result of the transaction fields, and counting register set number fields in the eleventh preset time period before the current time point, to obtain a count result of the register set number fields; and

obtaining respective feature data tables corresponding to the memory log data according to the summation result of the transaction fields and the count result of the register set number fields;

in a case where the multiple types of log data further comprise the operating system kernel logs, the performing (102) feature engineering construction according to the multiple types of log data to obtain respective feature data tables corresponding to the multiple types of log data comprises:

counting various types of fields related to memory errors in the operating system kernel logs;

counting the various types of fields in a twelfth preset time period before the current time point, to obtain respective count results corresponding to the various types of fields; and

obtaining a feature data table corresponding to the operating system kernel logs according to the respective count results corresponding to the various types of fields;

in a case where the multiple types of log data further comprise the EDAC logs, the performing (102) feature engineering construction according to the multiple types of log data to obtain respective feature data tables corresponding to the multiple types of log data comprises:

counting, according to the EDAC logs, memory controller, MC, fields, page fields and offset fields in a thirteenth preset time period before the current time point, to obtain a count result of the MC fields, a count result of the page fields, and a count result of the offset fields; and

obtaining a feature data table corresponding to the EDAC logs according to the count result of the MC fields, the count result of the page fields, and the count result of the offset fields;

in a case where the multiple types of log data further comprise the performance data, the performing (102) feature engineering construction according to the multiple types of log data to obtain respective feature data tables corresponding to the multiple types of log data comprises:

averaging, according to the performance data, various types of performance data influencing the memory failure in a fourteenth preset time period before the current time point, to obtain average values of the various types of performance data; and

obtaining a feature data table corresponding to the performance data according to the average values of the various types of performance data; and

in a case where the multiple types of log data further comprise the environment and location information data, the performing (102) feature engineering construction according to the multiple types of log data to obtain respective feature data tables corresponding to the multiple types of log data comprises:

averaging, according to the environment and location information data, temperatures and humidities in a fifteenth preset time period before the current time point, to obtain an average value of the temperatures and an average value of the humidities; and

obtaining a feature data table corresponding to the environment and location information data according to the average value of the temperatures and the average value of the humidities.

5. The method according to claim 1, wherein the failure prediction model is obtained by training with a pre-collected training data set and a machine learning method, and the machine learning method has a preset loss function FocalLoss, which is expressed as:

$$L_{fl} = \begin{cases} -\alpha\left(1-y^{'}\right)^{\gamma}\log y^{'} & y=1 \\ -(1-\alpha)y^{'\gamma}\log\left(1-y^{'}\right) & y=0 \end{cases}$$

where $\alpha$ is a balance factor, $\gamma$ is a modulation parameter, y' is a sample predicted value, y is a sample label value, and $L_{fl}$ is an error between the sample predicted value and the sample label value.

6. The method according to claim 1, wherein each sample in the training data set is labeled with a label value that is determined by:

calculating a time interval between a time point corresponding to each sample and a time point corresponding to a sample with the memory failure; and

calculating a label value for each sample according to the time interval and a formula for mapping the time interval into an interval [0, 1];

wherein the formula is:

$$label = \frac{1}{1+e^{a*(X/T-1)}}$$

where label represents a calculated label value, X is the time interval, a is a first preset coefficient, and T is a preset failure influence duration.

7. The method according to claim 1, wherein the acquiring (101) multiple types of log data of the memory under test comprises:

acquiring multiple types of log data of a memory under test on granularity of minutes; and

the performing (102) feature engineering construction according to the multiple types of log data to obtain respective feature data tables corresponding to the multiple types of log data comprises:

combining, when multiple types of log data within m minutes closest to a current time point are acquired, the multiple types of log data within the m minutes with multiple types of log data within n minutes before the m minutes, and taking the combined multiple types of log data as the log data desired for failure prediction at the current time point; where a preset shortest time length for failure prediction is n+m minutes; and

performing feature engineering construction on the granularity of minutes according to the log data desired for the failure prediction at the current time point, to obtain respective feature data tables corresponding to the multiple types of log data.

8. The method according to claim 5, wherein the obtaining (104) the failure prediction result of the memory under test according to the spliced feature data table and the pre-trained failure prediction model comprises:

   obtaining a confidence of classifying the memory under test into 1 according to the spliced feature data table and the pre-trained failure prediction model; and
   determining a health degree of the memory under test according to the confidence; wherein the health degree is 1-confidence, and the lower the health degree is, the more likely the memory under test has a failure.

9. The method according to claim 6, wherein the obtaining (104) the failure prediction result of the memory under test according to the spliced feature data table and the pre-trained failure prediction model comprises:

   obtaining a predicted value of the memory under test according to the spliced feature data table and the pre-trained failure prediction model, wherein the predicted value is a floating-point number between 0 and 1; and
   determining a health degree of the memory under test according to the predicted value, wherein the health degree is 1-predicted value, and the lower the health degree is, the more likely the memory under test has a failure.

10. A data processing device for predicting a memory failure for a memory under test, comprising:

   a log data acquiring module configured to acquire multiple types of log data of the memory under test, wherein the multiple types of log data include at least: memory error information address data;
   a feature engineering construction module configured to perform feature engineering construction according to the multiple types of log data, to obtain respective feature data tables corresponding to the multiple types of log data;
   a splicing module configured to splice the respective feature data tables corresponding to the multiple types of log data, to obtain a spliced feature data table; and
   a failure prediction module configured to obtain a failure prediction result of the memory under test according to the spliced feature data table and a pre-trained failure prediction model, wherein the failure prediction model is obtained by training with a pre-collected training data set, and samples in the training data set comprise multiple types of log data of multiple types of memories,
   **characterized in that**,
   the obtaining the failure prediction result of the memory under test according to the spliced feature data table and the pre-trained failure prediction model comprises:

      obtaining an output result of the failure prediction model according to the spliced feature data table and the pre-trained failure prediction model;
      obtaining a prediction result of a time point at which the memory under test has a failure according to the output result and a formula for predicting the time point of the failure;
      wherein the formula is:

$$t = b * \ln\left(\frac{1}{output} - 1\right) + T$$

      where t represents the time point at which the memory under test has the failure, b is a second preset coefficient, output is the output result, and T is a preset failure influence duration.

11. A computer-readable storage medium having a computer program stored thereon, wherein the computer program, when executed by a processor, causes the processor to implement a prediction of a memory failure for a memory under test, wherein the computer program comprises:

   a log data acquiring instruction for acquiring multiple types of log data of the memory under test, wherein the multiple types of log data include at least: memory error information address data;
   a feature engineering construction instruction for performing feature engineering construction according to the multiple types of log data, to obtain respective feature data tables corresponding to the multiple types of log data;
   a splicing instruction for splicing the respective feature data tables corresponding to the multiple types of log data, to obtain a spliced feature data table; and
   a failure prediction instruction for obtaining a failure prediction result of the memory under test according to the spliced feature data table and a pre-trained failure prediction model, wherein the failure prediction model is obtained by training with a pre-collected training data set, and samples in the training data set comprise multiple types of log data of multiple types of memories,

**characterized in that**,

the obtaining the failure prediction result of the memory under test according to the spliced feature data table and the pre-trained failure prediction model comprises:

obtaining an output result of the failure prediction model according to the spliced feature data table and the pre-trained failure prediction model;

obtaining a prediction result of a time point at which the memory under test has a failure according to the output result and a formula for predicting the time point of the failure;

wherein the formula is:

$$t = b * \ln\left(\frac{1}{output} - 1\right) + T$$

where t represents the time point at which the memory under test has the failure, b is a second preset coefficient, output is the output result, and T is a preset failure influence duration.

## Patentansprüche

1. Verfahren zum Vorhersagen eines Speicherausfalls für einen zu testenden Speicher, umfassend:

Erfassen (101) mehrerer Typen von Protokolldaten des zu testenden Speichers, wobei die mehreren Typen von Protokolldaten mindestens einschließen: Speicherfehlerinformations-Adressdaten;

Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen;

Zusammenfügen (103) der jeweiligen Merkmalsdatentabellen, die den mehreren Typen von Protokolldaten entsprechen, um eine zusammengefügte Merkmalsdatentabelle zu erhalten; und

Erhalten (104) eines Ausfallvorhersageergebnisses des zu testenden Speichers gemäß der zusammengefügten Merkmalsdatentabelle und einem vortrainierten Ausfallvorhersagemodell, wobei das Ausfallvorhersagemodell durch Trainieren mit einem vorgesammelten Trainingsdatensatz erhalten wird und Abtastungen in dem Trainingsdatensatz mehrere Typen von Protokolldaten von mehreren Typen von Speichern umfassen,

**dadurch gekennzeichnet, dass** das Erhalten (104) des Ausfallvorhersageergebnisses des zu testenden Speichers gemäß der zusammengefügten Merkmalsdatentabelle und dem vortrainierten Ausfallvorhersagemodell umfasst:

Erhalten eines Ausgabeergebnisses des Ausfallvorhersagemodells gemäß der zusammengefügten Merkmalsdatentabelle und dem vortrainierten Ausfallvorhersagemodell;

Erhalten eines Vorhersageergebnisses eines Zeitpunkts, zu dem der zu testende Speicher einen Ausfall aufweist, gemäß dem Ausgabeergebnis und einer Formel zum Vorhersagen des Zeitpunkts des Ausfalls; wobei die Formel lautet:

$$t = b * \ln\left(\frac{1}{output} - 1\right) + T$$

wobei t den Zeitpunkt repräsentiert, zu dem der zu testende Speicher den Ausfall aufweist, b ein zweiter voreingestellter Koeffizient ist, output das Ausgabeergebnis ist und T eine voreingestellte Ausfalleinflussdauer ist.

2. Verfahren nach Anspruch 1, wobei das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Zählen, gemäß den Speicherfehlerinformations-Adressdaten, einer ersten Anzahl von ersten Zielen, die in einem ersten voreingestellten Zeitraum vor einem aktuellen Zeitpunkt erscheinen, und einer ersten Anzahl von Malen von Fehlerprüfung und -korrektur, ECC, die auf jedem ersten Ziel erscheinen, wobei jedes der ersten Ziele eine Zelle unter Zellen in dem zu testenden Speicher ist, auf der ECC 2-mal oder öfter in einem vergangenen zweiten voreingestellten Zeitraum erscheint, und der zweite voreingestellte Zeitraum eine Dauer aufweist, die länger als der erste voreingestellte Zeitraum ist;

Zählen, gemäß den Speicherfehlerinformations-Adressdaten, einer zweiten Anzahl von zweiten Zielen, die in einem dritten voreingestellten Zeitraum vor dem aktuellen Zeitpunkt erscheinen, und einer zweiten Anzahl von Malen von ECC, die auf jedem zweiten Ziel erscheinen, wobei jedes der zweiten Ziele eine Spalte von Zellen unter Spalten von Zellen in dem zu testenden Speicher ist, auf der ECC insgesamt 2-mal oder öfter zu einem gleichen Zeitpunkt in einem vergangenen vierten voreingestellten Zeitraum erscheint, und der vierte voreingestellte Zeitraum eine Dauer aufweist, die länger als der dritte voreingestellte Zeitraum ist;

Zählen, gemäß den Speicherfehlerinformations-Adressdaten, einer dritten Anzahl von dritten Zielen, die in einem fünften voreingestellten Zeitraum vor dem aktuellen Zeitpunkt erscheinen, und einer dritten Anzahl von Malen von ECC, die auf jedem dritten Ziel erscheinen, wobei jedes der dritten Ziele eine Zeile von Zellen unter Zeilen von Zellen in dem zu testenden Speicher ist, auf der ECC insgesamt 2-mal oder öfter zu einem gleichen Zeitpunkt in einem vergangenen sechsten voreingestellten Zeitraum erscheint, und der sechste voreingestellte Zeitraum eine Dauer aufweist, die länger als der fünfte voreingestellte Zeitraum ist;

Zählen, gemäß den Speicherfehlerinformations-Adressdaten, einer vierten Anzahl von vierten Zielen, die in einem siebten voreingestellten Zeitraum vor dem aktuellen Zeitpunkt erscheinen, wobei jedes der vierten Ziele ein Zellenblock ist, der aus mindestens drei Zellen in einer gleichen Spalte in dem zu testenden Speicher besteht, die mindestens drei Zellen in der gleichen Spalte ECC zu einem gleichen Zeitpunkt in einem vergangenen achten voreingestellten Zeitraum aufweisen und höchstens durch eine Zelle voneinander getrennt sind, und der achte voreingestellte Zeitraum eine Dauer aufweist, die länger als der siebte voreingestellte Zeitraum ist;

Zählen, gemäß den Speicherfehlerinformations-Adressdaten, einer fünften Anzahl von fünften Zielen, die in einem neunten voreingestellten Zeitraum vor dem aktuellen Zeitpunkt erscheinen, wobei jedes der fünften Ziele ein Zellenblock ist, der aus mindestens drei Zellen in einer gleichen Zeile in dem zu testenden Speicher besteht, die mindestens drei Zellen in der gleichen Zeile ECC zu einem gleichen Zeitpunkt in einem vergangenen zehnten voreingestellten Zeitraum aufweisen und höchstens durch eine Zelle voneinander getrennt sind, und der zehnte voreingestellte Zeitraum eine Dauer aufweist, die länger als der neunte voreingestellte Zeitraum ist; und

Erhalten einer Merkmalsdatentabelle, die den Speicherfehlerinformations-Adressdaten entspricht, gemäß einem oder einer beliebigen Kombination von:

der ersten Anzahl, der ersten Anzahl von Malen, der zweiten Anzahl, der zweiten Anzahl von Malen, der dritten Anzahl, der dritten Anzahl von Malen, der vierten Anzahl oder der fünften Anzahl.

3. Verfahren nach Anspruch 1 oder 2, wobei die mehreren Typen von Protokolldaten ferner eines oder eine beliebige Kombination von Folgendem umfassen:

Speicher-Protokolldaten, Betriebssystem-Kernel-Protokolle, Fehlererkennungs- und -korrektur-Protokolle, EDAC-Protokolle, Leistungsdaten oder Umgebungs- und Standortinformationsdaten.

4. Verfahren nach Anspruch 3, wobei

in einem Fall, in dem die mehreren Typen von Protokolldaten ferner die Speicher-Protokolldaten umfassen, das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Summieren, gemäß den Speicher-Protokolldaten, von Transaktionsfeldern in einem elften voreingestellten Zeitraum vor dem aktuellen Zeitpunkt, um ein Summierungsergebnis der Transaktionsfelder zu erhalten, und Zählen von Registereinstellanzahlfeldern in dem elften voreingestellten Zeitraum vor dem aktuellen Zeitpunkt, um ein Zählergebnis der Registereinstellanzahlfelder zu erhalten; und

Erhalten jeweiliger Merkmalsdatentabellen, die den Speicher-Protokolldaten entsprechen, gemäß dem Summierungsergebnis der Transaktionsfelder und dem Zählergebnis der Registereinstellanzahlfelder;

in einem Fall, in dem die mehreren Typen von Protokolldaten ferner die Betriebssystem-Kernel-Protokolle umfassen, das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Zählen verschiedener Typen von Feldern, die sich auf Speicherfehler in den Betriebssystem-Kernel-Protokollen beziehen;

Zählen der verschiedenen Typen von Feldern in einem zwölften voreingestellten Zeitraum vor dem aktuellen Zeitpunkt, um jeweilige Zählergebnisse zu erhalten, die den verschiedenen Typen von Feldern entsprechen;

und

Erhalten einer Merkmalsdatentabelle, die den Betriebssystem-Kernel-Protokollen entspricht, gemäß den jeweiligen Zählergebnissen, die den verschiedenen Typen von Feldern entsprechen;

in einem Fall, in dem die mehreren Typen von Protokolldaten ferner die EDAC-Protokolle umfassen, das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Zählen, gemäß den EDAC-Protokollen, von Speicher-Steuerfeldern, MC-Feldern, Seitenfeldern und Versatzfeldern in einem dreizehnten voreingestellten Zeitraum vor dem aktuellen Zeitpunkt, um ein Zählergebnis der MC-Felder, ein Zählergebnis der Seitenfelder und ein Zählergebnis der Versatzfelder zu erhalten; und

Erhalten einer Merkmalsdatentabelle, die den EDAC-Protokollen entspricht, gemäß dem Zählergebnis der MC-Felder, dem Zählergebnis der Seitenfelder und dem Zählergebnis der Versatzfelder;

in einem Fall, in dem die mehreren Typen von Protokolldaten ferner die Leistungsdaten umfassen, das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Mitteln, gemäß den Leistungsdaten, verschiedener Typen von Leistungsdaten, die den Speicherausfall beeinflussen, in einem vierzehnten voreingestellten Zeitraum vor dem aktuellen Zeitpunkt, um Mittelwerte der verschiedenen Typen von Leistungsdaten zu erhalten; und

Erhalten einer Merkmalsdatentabelle, die den Leistungsdaten entspricht, gemäß den Mittelwerten der verschiedenen Typen von Leistungsdaten; und

in einem Fall, in dem die mehreren Typen von Protokolldaten ferner die Umgebungs- und Standortinformationsdaten umfassen, das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Mitteln, gemäß den Umgebungs- und Standortinformationsdaten, von Temperaturen und Feuchtigkeiten in einem fünfzehnten voreingestellten Zeitraum vor dem aktuellen Zeitpunkt, um einen Mittelwert der Temperaturen und einen Mittelwert der Feuchtigkeiten zu erhalten; und

Erhalten einer Merkmalsdatentabelle, die den Umgebungs- und Standortinformationsdaten entspricht, gemäß dem Mittelwert der Temperaturen und dem Mittelwert der Feuchtigkeiten.

5. Verfahren nach Anspruch 1, wobei das Ausfallvorhersagemodell durch Trainieren mit einem vorgesammelten Trainingsdatensatz und einem maschinellen Lernverfahren erhalten wird und das maschinelle Lernverfahren eine voreingestellte Verlustfunktion FocalLoss aufweist, die ausgedrückt wird als:

$$L_{fl} = \begin{cases} -\alpha \left(1 - y'\right)^{\gamma} \log y' & y = 1 \\ -(1-\alpha) y'^{\gamma} \log\left(1 - y'\right) & y = 0 \end{cases}$$

wobei $\alpha$ ein Ausgleichsfaktor ist, $\gamma$ ein Modulationsparameter ist, y' ein abgetasteter vorhergesagter Wert ist, y ein abgetasteter Etikettenwert ist und $L_{fl}$ ein Fehler zwischen dem abgetasteten vorhergesagten Wert und dem abgetasteten Etikettenwert ist.

6. Verfahren nach Anspruch 1, wobei jede Abtastung in dem Trainingsdatensatz mit einem Etikettenwert gekennzeichnet ist, der bestimmt wird durch:

Berechnen eines Zeitintervalls zwischen einem Zeitpunkt, der jeder Abtastung entspricht, und einem Zeitpunkt, der einer Abtastung mit dem Speicherausfall entspricht; und

Berechnen eines Etikettenwerts für jede Abtastung gemäß dem Zeitintervall und einer Formel zum Abbilden des Zeitintervalls in ein Intervall [0, 1];

wobei die Formel lautet:

$$label = \frac{1}{1 + e^{a*(X/T-1)}}$$

wobei label einen berechneten Etikettenwert repräsentiert, X das Zeitintervall ist, a ein erster voreingestellter Koeffizient ist und T eine voreingestellte Ausfalleinflussdauer ist.

7. Verfahren nach Anspruch 1, wobei das Erfassen (101) mehrerer Typen von Protokolldaten des zu testenden Speichers Folgendes umfasst:

Erfassen mehrerer Typen von Protokolldaten eines zu testenden Speichers auf Minutengranularität; und das Durchführen (102) einer Merkmalstechnikkonstruktion gemäß den mehreren Typen von Protokolldaten, um jeweilige Merkmalsdatentabellen zu erhalten, die den mehreren Typen von Protokolldaten entsprechen, Folgendes umfasst:

Kombinieren, wenn mehrere Typen von Protokolldaten innerhalb von m Minuten, die einem aktuellen Zeitpunkt am nächsten sind, erfasst werden, der mehreren Typen von Protokolldaten innerhalb der m Minuten mit mehreren Typen von Protokolldaten innerhalb von n Minuten vor den m Minuten und Nehmen der kombinierten mehreren Typen von Protokolldaten als die Protokolldaten, die für eine Ausfallvorhersage zu dem aktuellen Zeitpunkt gewünscht sind; wobei eine voreingestellte kürzeste Zeitdauer für eine Ausfallvorhersage n+m Minuten beträgt; und Durchführen einer Merkmalstechnikkonstruktion auf der Minutengranularität gemäß den Protokolldaten, die für die Ausfallvorhersage zu dem aktuellen Zeitpunkt gewünscht sind, um jeweilige Merkmalsdatentabellen zu erhalten, die den mehreren Typen von Protokolldaten entsprechen.

8. Verfahren nach Anspruch 5, wobei das Erhalten (104) des Ausfallvorhersageergebnisses des zu testenden Speichers gemäß der zusammengefügten Merkmalsdatentabelle und dem vortrainierten Ausfallvorhersagemodell Folgendes umfasst:

Erhalten einer Konfidenz des Klassifizierens des zu testenden Speichers in 1 gemäß der zusammengefügten Merkmalsdatentabelle und dem vortrainierten Ausfallvorhersagemodell; und Bestimmen eines Gesundheitsgrads des zu testenden Speichers gemäß der Konfidenz; wobei der Gesundheitsgrad 1-Konfidenz ist und je niedriger der Gesundheitsgrad ist, desto wahrscheinlicher ist, dass der zu testende Speicher einen Ausfall aufweist.

9. Verfahren nach Anspruch 6, wobei das Erhalten (104) des Ausfallvorhersageergebnisses des zu testenden Speichers gemäß der zusammengefügten Merkmalsdatentabelle und dem vortrainierten Ausfallvorhersagemodell Folgendes umfasst:

Erhalten eines vorhergesagten Werts des zu testenden Speichers gemäß der zusammengefügten Merkmalsdatentabelle und dem vortrainierten Ausfallvorhersagemodell, wobei der vorhergesagte Wert eine Gleitkommaanzahl zwischen 0 und 1 ist; und Bestimmen eines Gesundheitsgrads des zu testenden Speichers gemäß dem vorhergesagten Wert, wobei der Gesundheitsgrad 1-vorhergesagter Wert ist und je niedriger der Gesundheitsgrad ist, desto wahrscheinlicher ist, dass der zu testende Speicher einen Ausfall aufweist.

10. Vorrichtung zum Verarbeiten von Daten zum Vorhersagen eines Speicherausfalls für einen zu testenden Speicher, umfassend:

ein Protokolldaten-Erfassungsmodul, das konfiguriert ist, um mehrere Typen von Protokolldaten des zu testenden Speichers zu erfassen, wobei die mehreren Typen von Protokolldaten mindestens einschließen: Speicherfehlerinformations-Adressdaten; ein Merkmalstechnikkonstruktionsmodul, das konfiguriert ist, um eine Merkmalstechnikkonstruktion gemäß den mehreren Typen von Protokolldaten durchzuführen, um jeweilige Merkmalsdatentabellen zu erhalten, die den mehreren Typen von Protokolldaten entsprechen; ein Zusammenfügungsmodul, das konfiguriert ist, um die jeweiligen Merkmalsdatentabellen zusammenzufügen, die den mehreren Typen von Protokolldaten entsprechen, um eine zusammengefügte Merkmalsdatentabelle zu erhalten; und

ein Ausfallvorhersagemodul, das konfiguriert ist, um ein Ausfallvorhersageergebnis des zu testenden Speichers gemäß der zusammengefügten Merkmalsdatentabelle und einem vortrainierten Ausfallvorhersagemodell zu erhalten, wobei das Ausfallvorhersagemodell durch Trainieren mit einem vorgesammelten Trainingsdatensatz erhalten wird und Abtastungen in dem Trainingsdatensatz mehrere Typen von Protokolldaten von mehreren Typen von Speichern umfassen,

**dadurch gekennzeichnet, dass**

das Erhalten des Ausfallvorhersageergebnisses des zu testenden Speichers gemäß der zusammengefügten Merkmalsdatentabelle und dem vortrainierten Ausfallvorhersagemodell Folgendes umfasst:

Erhalten eines Ausgabeergebnisses des Ausfallvorhersagemodells gemäß der zusammengefügten Merkmalsdatentabelle und dem vortrainierten Ausfallvorhersagemodell;
Erhalten eines Vorhersageergebnisses eines Zeitpunkts, zu dem der zu testende Speicher einen Ausfall aufweist, gemäß dem Ausgabeergebnis und einer Formel zum Vorhersagen des Zeitpunkts des Ausfalls; wobei die Formel lautet:

$$t = b * \ln\left(\frac{1}{\text{output}} - 1\right) + T$$

wobei t den Zeitpunkt repräsentiert, zu dem der zu testende Speicher den Ausfall aufweist, b ein zweiter voreingestellter Koeffizient ist, output das Ausgabeergebnis ist und T eine voreingestellte Ausfalleinflussdauer ist.

11. Computerlesbares Speichermedium mit einem darauf gespeicherten Computerprogramm, wobei das Computerprogramm, wenn es von einem Prozessor ausgeführt wird, den Prozessor veranlasst, eine Vorhersage eines Speicherausfalls für einen zu testenden Speicher zu implementieren, wobei das Computerprogramm umfasst:

eine Protokolldaten-Erfassungsanweisung zum Erfassen mehrerer Typen von Protokolldaten des zu testenden Speichers, wobei die mehreren Typen von Protokolldaten mindestens einschließen: Speicherfehlerinformations-Adressdaten;
eine Merkmalstechnikkonstruktionsanweisung zum Durchführen einer Merkmalstechnikkonstruktion gemäß den mehreren Typen von Protokolldaten, um jeweilige Merkmalsdatentabellen zu erhalten, die den mehreren Typen von Protokolldaten entsprechen;
eine Zusammenfügungsanweisung zum Zusammenfügen der jeweiligen Merkmalsdatentabellen, die den mehreren Typen von Protokolldaten entsprechen, um eine zusammengefügte Merkmalsdatentabelle zu erhalten; und
eine Ausfallvorhersageanweisung zum Erhalten eines Ausfallvorhersageergebnisses des zu testenden Speichers gemäß der zusammengefügten Merkmalsdatentabelle und einem vortrainierten Ausfallvorhersagemodell, wobei das Ausfallvorhersagemodell durch Trainieren mit einem vorgesammelten Trainingsdatensatz erhalten wird und Abtastungen in dem Trainingsdatensatz mehrere Typen von Protokolldaten von mehreren Typen von Speichern umfassen,

**dadurch gekennzeichnet, dass**

das Erhalten des Ausfallvorhersageergebnisses des zu testenden Speichers gemäß der zusammengefügten Merkmalsdatentabelle und dem vortrainierten Ausfallvorhersagemodell Folgendes umfasst:

Erhalten eines Ausgabeergebnisses des Ausfallvorhersagemodells gemäß der zusammengefügten Merkmalsdatentabelle und dem vortrainierten Ausfallvorhersagemodell;
Erhalten eines Vorhersageergebnisses eines Zeitpunkts, zu dem der zu testende Speicher einen Ausfall aufweist, gemäß dem Ausgabeergebnis und einer Formel zum Vorhersagen des Zeitpunkts des Ausfalls; wobei die Formel lautet:

$$t = b * \ln\left(\frac{1}{\text{output}} - 1\right) + T$$

wobei t den Zeitpunkt repräsentiert, zu dem der zu testende Speicher den Ausfall aufweist, b ein zweiter voreingestellter Koeffizient ist, output das Ausgabeergebnis ist und T eine voreingestellte Ausfalleinflussdauer ist.

**Revendications**

1. Procédé pour prédire une défaillance de mémoire pour une mémoire en cours de test, comprenant les étapes consistant à :

   acquérir (101) de multiples types de données de journal de la mémoire en cours de test, dans lequel les multiples types de données de journal incluent au moins : des données d'adresse d'informations d'erreur de mémoire ;
   réaliser (102) une construction d'ingénierie de caractéristiques selon les multiples types de données de journal, pour obtenir des tables de données de caractéristiques respectives correspondant aux multiples types de données de journal ;
   assembler (103) les tables de données de caractéristiques respectives correspondant aux multiples types de données de journal, pour obtenir une table de données de caractéristiques assemblée ; et
   obtenir (104) un résultat de prédiction de défaillance de la mémoire en cours de test selon la table de données de caractéristiques assemblée et un modèle de prédiction de défaillance pré-entraîné, dans lequel le modèle de prédiction de défaillance est obtenu en s'entraînant avec un ensemble de données d'entraînement pré-collectées, et des échantillons dans l'ensemble de données d'entraînement comprennent de multiples types de données de journal de multiples types de mémoires,
   **caractérisé en ce que** obtenir (104) le résultat de prédiction de défaillance de la mémoire en cours de test selon la table de données de caractéristiques assemblée et le modèle de prédiction de défaillance pré-entraîné comprend les étapes consistant à :

      obtenir un résultat de délivrance du modèle de prédiction de défaillance selon la table de données de caractéristiques assemblée et le modèle de prédiction de défaillance pré-entraîné ;
      obtenir un résultat de prédiction d'un point temporel auquel la mémoire en cours de test présente une défaillance selon le résultat de délivrance et une formule pour prédire le point temporel de la défaillance ;
      dans lequel la formule est :

      $$t = b * \ln\left(\frac{1}{output} - 1\right) + T$$

      où t représente le point temporel auquel la mémoire en cours de test présente la défaillance, b est un second coefficient prédéfini, output est le résultat de délivrance, et T est une durée d'influence de défaillance prédéfinie.

2. Procédé selon la revendication 1, dans lequel réaliser (102) une construction d'ingénierie de caractéristiques selon les multiples types de données de journal pour obtenir des tables de données de caractéristiques respectives correspondant aux multiples types de données de journal comprend :

   compter, selon les données d'adresse d'informations d'erreur de mémoire, un premier nombre de premières cibles apparaissant dans une première période de temps prédéfinie avant un point temporel actuel, et un premier nombre d'occurrences de vérification et de correction d'erreur, ECC, apparaissant sur chaque première cible, dans lequel chacune des premières cibles est une cellule, parmi des cellules dans la mémoire en cours de test, sur laquelle ECC apparaît 2 fois ou plus dans une deuxième période de temps prédéfinie passée, et la deuxième période de temps prédéfinie présente une durée plus longue que la première période de temps prédéfinie ;
   compter, selon les données d'adresse d'informations d'erreur de mémoire, un deuxième nombre de deuxièmes cibles apparaissant dans une troisième période de temps prédéfinie avant le point temporel actuel, et un deuxième nombre d'occurrences d'ECC apparaissant sur chaque deuxième cible, dans lequel chacune des deuxièmes cibles est une colonne de cellules, parmi des colonnes de cellules dans la mémoire en cours de test, sur laquelle ECC apparaît 2 fois ou plus au total à un même point temporel dans une quatrième période de temps prédéfinie passée, et la quatrième période de temps prédéfinie présente une durée plus longue que la troisième période de temps prédéfinie ;
   compter, selon les données d'adresse d'informations d'erreur de mémoire, un troisième nombre de troisièmes cibles apparaissant dans une cinquième période de temps prédéfinie avant le point temporel actuel, et un troisième nombre d'occurrences d'ECC apparaissant sur chaque troisième cible, dans lequel chacune des troisièmes cibles est une rangée de cellules, parmi des rangées de cellules dans la mémoire en cours de test, sur laquelle ECC apparaît 2 fois ou plus au total à un même point temporel dans une sixième période de temps prédéfinie passée, et la sixième période de temps prédéfinie présente une durée plus longue que la cinquième période de temps prédéfinie ;

compter, selon les données d'adresse d'informations d'erreur de mémoire, un quatrième nombre de quatrièmes cibles apparaissant dans une septième période de temps prédéfinie avant le point temporel actuel, dans lequel chacune des quatrièmes cibles est un bloc de cellules constitué d'au moins trois cellules dans une même colonne dans la mémoire en cours de test, les au moins trois cellules dans la même colonne présentent ECC à un même point temporel dans une huitième période de temps prédéfinie passée et sont séparées les unes des autres par une cellule au maximum, et la huitième période de temps prédéfinie présente une durée plus longue que la septième période de temps prédéfinie ;

compter, selon les données d'adresse d'informations d'erreur de mémoire, un cinquième nombre de cinquièmes cibles apparaissant dans une neuvième période de temps prédéfinie avant le point temporel actuel, dans lequel chacune des cinquièmes cibles est un bloc de cellules constitué d'au moins trois cellules dans une même rangée dans la mémoire en cours de test, les au moins trois cellules dans la même rangée présentent ECC à un même point temporel dans une dixième période de temps prédéfinie passée et sont séparées les unes des autres par une cellule au maximum, et la dixième période de temps prédéfinie présente une durée plus longue que la neuvième période de temps prédéfinie ; et

obtenir une table de données de caractéristiques correspondant aux données d'adresse d'informations d'erreur de mémoire selon l'une quelconque ou une combinaison quelconque des étapes consistant à :

le premier nombre, le premier nombre d'occurrences, le deuxième nombre, le deuxième nombre d'occurrences, le troisième nombre, le troisième nombre d'occurrences, le quatrième nombre, ou le cinquième nombre.

3. Procédé selon la revendication 1 ou 2, dans lequel les multiples types de données de journal comprennent en outre l'une quelconque ou une combinaison quelconque des étapes consistant à :

des données de journal de mémoire, des journaux de noyau de système d'exploitation, des journaux de détection et de correction d'erreur, EDAC, des données de performance, ou des données d'informations d'environnement et de localisation.

4. Procédé selon la revendication 3, dans lequel

dans un cas où les multiples types de données de journal comprennent en outre les données de journal de mémoire, réaliser (102) une construction d'ingénierie de caractéristiques selon les multiples types de données de journal pour obtenir des tables de données de caractéristiques respectives correspondant aux multiples types de données de journal comprend :

sommer, selon les données de journal de mémoire, des champs de transaction dans une onzième période de temps prédéfinie avant le point temporel actuel, pour obtenir un résultat de sommation des champs de transaction, et compter des champs de nombre défini de registre dans la onzième période de temps prédéfinie avant le point temporel actuel, pour obtenir un résultat de comptage des champs de nombre défini de registre ; et obtenir des tables de données de caractéristiques respectives correspondant aux données de journal de mémoire selon le résultat de sommation des champs de transaction et le résultat de comptage des champs de nombre défini de registre ;

dans un cas où les multiples types de données de journal comprennent en outre les journaux de noyau de système d'exploitation, réaliser (102) une construction d'ingénierie de caractéristiques selon les multiples types de données de journal pour obtenir des tables de données de caractéristiques respectives correspondant aux multiples types de données de journal comprend :

compter divers types de champs liés à des erreurs de mémoire dans les journaux de noyau de système d'exploitation ;

compter les divers types de champs dans une douzième période de temps prédéfinie avant le point temporel actuel, pour obtenir des résultats de comptage respectifs correspondant aux divers types de champs ; et obtenir une table de données de caractéristiques correspondant aux journaux de noyau de système d'exploitation selon les résultats de comptage respectifs correspondant aux divers types de champs ;

dans un cas où les multiples types de données de journal comprennent en outre les journaux EDAC, réaliser (102) une construction d'ingénierie de caractéristiques selon les multiples types de données de journal pour obtenir des tables de données de caractéristiques respectives correspondant aux multiples types de données de journal comprend :

compter, selon les journaux EDAC, des champs de contrôleur de mémoire, MC, des champs de page et des champs de décalage dans une treizième période de temps prédéfinie avant le point temporel actuel, pour obtenir un résultat de comptage des champs MC, un résultat de comptage des champs de page, et un résultat de comptage des champs de décalage ; et

obtenir une table de données de caractéristiques correspondant aux journaux EDAC selon le résultat de comptage des champs MC, le résultat de comptage des champs de page, et le résultat de comptage des champs de décalage ;

dans un cas où les multiples types de données de journal comprennent en outre les données de performance, réaliser (102) une construction d'ingénierie de caractéristiques selon les multiples types de données de journal pour obtenir des tables de données de caractéristiques respectives correspondant aux multiples types de données de journal comprend :

moyenner, selon les données de performance, divers types de données de performance influençant la défaillance de mémoire dans une quatorzième période de temps prédéfinie avant le point temporel actuel, pour obtenir des valeurs moyennes des divers types de données de performance ; et

obtenir une table de données de caractéristiques correspondant aux données de performance selon les valeurs moyennes des divers types de données de performance ; et

dans un cas où les multiples types de données de journal comprennent en outre les données d'informations d'environnement et de localisation, réaliser (102) une construction d'ingénierie de caractéristiques selon les multiples types de données de journal pour obtenir des tables de données de caractéristiques respectives correspondant aux multiples types de données de journal comprend :

moyenner, selon les données d'informations d'environnement et de localisation, des températures et des humidités dans une quinzième période de temps prédéfinie avant le point temporel actuel, pour obtenir une valeur moyenne des températures et une valeur moyenne des humidités ; et

obtenir une table de données de caractéristiques correspondant aux données d'informations d'environnement et de localisation selon la valeur moyenne des températures et la valeur moyenne des humidités.

5. Procédé selon la revendication 1, dans lequel le modèle de prédiction de défaillance est obtenu en s'entraînant avec un ensemble de données d'entraînement pré-collectées et un procédé d'apprentissage automatique, et le procédé d'apprentissage automatique a une fonction de perte prédéfinie FocalLoss, qui est exprimée comme :

$$
L_{fl} = \begin{cases} -\alpha \left(1 - y^{'}\right)^{\gamma} \log y^{'} & y = 1 \\ -(1-\alpha)y^{'\gamma} \log\left(1 - y^{'}\right) & y = 0 \end{cases}
$$

où $\alpha$ est un facteur d'équilibre, $\gamma$ est un paramètre de modulation, y' est une valeur prédite d'échantillon, y est une valeur d'étiquette d'échantillon, et $L_{fl}$ est une erreur entre la valeur prédite d'échantillon et la valeur d'étiquette d'échantillon.

6. Procédé selon la revendication 1, dans lequel chaque échantillon dans l'ensemble de données d'entraînement est étiqueté avec une valeur d'étiquette qui est déterminée en :

calculer un intervalle de temps entre un point temporel correspondant à chaque échantillon et un point temporel correspondant à un échantillon présentant la défaillance de mémoire ; et

calculer une valeur d'étiquette pour chaque échantillon selon l'intervalle de temps et une formule pour mapper l'intervalle de temps dans un intervalle [0, 1] ;

dans lequel la formule est :

$$
label = \frac{1}{1 + e^{a^{*}(X/T-1)}}
$$

où label représente une valeur d'étiquette calculée, X est l'intervalle de temps, a est un premier coefficient prédéfini, et T est une durée d'influence de défaillance prédéfinie.

7. Procédé selon la revendication 1, dans lequel acquérir (101) de multiples types de données de journal de la mémoire en cours de test comprend les étapes consistant à :

acquérir de multiples types de données de journal d'une mémoire en cours de test sur une granularité de minutes ; et

réaliser (102) une construction d'ingénierie de caractéristiques selon les multiples types de données de journal pour obtenir des tables de données de caractéristiques respectives correspondant aux multiples types de données de journal comprend les étapes consistant à :

combiner, lorsque de multiples types de données de journal dans les m minutes les plus proches d'un point temporel actuel sont acquis, les multiples types de données de journal dans les m minutes avec de multiples types de données de journal dans les n minutes avant les m minutes, et prendre les multiples types combinés de données de journal en tant que données de journal souhaitées pour une prédiction de défaillance au point temporel actuel ; où une longueur de temps la plus courte prédéfinie pour une prédiction de défaillance est n+m minutes ; et

réaliser une construction d'ingénierie de caractéristiques sur la granularité de minutes selon les données de journal souhaitées pour la prédiction de défaillance au point temporel actuel, pour obtenir des tables de données de caractéristiques respectives correspondant aux multiples types de données de journal.

8. Procédé selon la revendication 5, dans lequel obtenir (104) le résultat de prédiction de défaillance de la mémoire en cours de test selon la table de données de caractéristiques assemblée et le modèle de prédiction de défaillance pré-entraîné comprend les étapes consistant à :

obtenir une confiance consistant à classer la mémoire en cours de test en 1 selon la table de données de caractéristiques assemblée et le modèle de prédiction de défaillance pré-entraîné ; et

déterminer un degré de santé de la mémoire en cours de test selon la confiance ; dans lequel le degré de santé est 1-confiance, et plus le degré de santé est bas, plus la mémoire en cours de test est susceptible d'avoir une défaillance.

9. Procédé selon la revendication 6, dans lequel obtenir (104) le résultat de prédiction de défaillance de la mémoire en cours de test selon la table de données de caractéristiques assemblée et le modèle de prédiction de défaillance pré-entraîné comprend les étapes consistant à :

obtenir une valeur prédite de la mémoire en cours de test selon la table de données de caractéristiques assemblée et le modèle de prédiction de défaillance pré-entraîné, dans lequel la valeur prédite est un nombre à virgule flottante entre 0 et 1 ; et

déterminer un degré de santé de la mémoire en cours de test selon la valeur prédite, dans lequel le degré de santé est 1-valeur prédite, et plus le degré de santé est bas, plus la mémoire en cours de test est susceptible d'avoir une défaillance.

10. Dispositif de traitement de données pour prédire une défaillance de mémoire pour une mémoire en cours de test, comprenant :

un module d'acquisition de données de journal configuré pour acquérir de multiples types de données de journal de la mémoire en cours de test, dans lequel les multiples types de données de journal incluent au moins : des données d'adresse d'informations d'erreur de mémoire ;

un module de construction d'ingénierie de caractéristiques configuré pour réaliser une construction d'ingénierie de caractéristiques selon les multiples types de données de journal, pour obtenir des tables de données de caractéristiques respectives correspondant aux multiples types de données de journal ;

un module d'assemblage configuré pour assembler les tables de données de caractéristiques respectives correspondant aux multiples types de données de journal, pour obtenir une table de données de caractéristiques assemblée ; et

un module de prédiction de défaillance configuré pour obtenir un résultat de prédiction de défaillance de la mémoire en cours de test selon la table de données de caractéristiques assemblée et un modèle de prédiction de défaillance pré-entraîné, dans lequel le modèle de prédiction de défaillance est obtenu en s'entraînant avec un ensemble de données d'entraînement pré-collectées, et des échantillons dans l'ensemble de données d'entraînement comprennent de multiples types de données de journal de multiples types de mémoires, **caractérisé en ce que**

obtenir le résultat de prédiction de défaillance de la mémoire en cours de test selon la table de données de caractéristiques assemblée et le modèle de prédiction de défaillance pré-entraîné comprend les étapes consistant à :

obtenir un résultat de délivrance du modèle de prédiction de défaillance selon la table de données de caractéristiques assemblée et le modèle de prédiction de défaillance pré-entraîné ;
obtenir un résultat de prédiction d'un point temporel auquel la mémoire en cours de test présente une défaillance selon le résultat de délivrance et une formule pour prédire le point temporel de la défaillance ;
dans lequel la formule est :

$$t = b*\ln\left(\frac{1}{\text{output}} - 1\right) + T$$

où t représente le point temporel auquel la mémoire en cours de test présente la défaillance, b est un second coefficient prédéfini, output est le résultat de délivrance, et T est une durée d'influence de défaillance prédéfinie.

11. Moyen de stockage lisible par ordinateur sur lequel est stocké un programme informatique, dans lequel le programme informatique, lorsqu'il est exécuté par un processeur, amène le processeur à mettre en œuvre une prédiction d'une défaillance de mémoire pour une mémoire en cours de test, dans lequel le programme informatique comprend :

une instruction d'acquisition de données de journal pour acquérir de multiples types de données de journal de la mémoire en cours de test, dans lequel les multiples types de données de journal incluent au moins : des données d'adresse d'informations d'erreur de mémoire ;
une instruction de construction d'ingénierie de caractéristiques pour réaliser une construction d'ingénierie de caractéristiques selon les multiples types de données de journal, pour obtenir des tables de données de caractéristiques respectives correspondant aux multiples types de données de journal ;
une instruction d'assemblage pour assembler les tables de données de caractéristiques respectives correspondant aux multiples types de données de journal, pour obtenir une table de données de caractéristiques assemblée ; et
une instruction de prédiction de défaillance pour obtenir un résultat de prédiction de défaillance de la mémoire en cours de test selon la table de données de caractéristiques assemblée et un modèle de prédiction de défaillance pré-entraîné, dans lequel le modèle de prédiction de défaillance est obtenu en s'entraînant avec un ensemble de données d'entraînement pré-collectées, et des échantillons dans l'ensemble de données d'entraînement comprennent de multiples types de données de journal de multiples types de mémoires,
**caractérisé en ce que**
obtenir le résultat de prédiction de défaillance de la mémoire en cours de test selon la table de données de caractéristiques assemblée et le modèle de prédiction de défaillance pré-entraîné comprend les étapes consistant à :

obtenir un résultat de délivrance du modèle de prédiction de défaillance selon la table de données de caractéristiques assemblée et le modèle de prédiction de défaillance pré-entraîné ;
obtenir un résultat de prédiction d'un point temporel auquel la mémoire en cours de test présente une défaillance selon le résultat de délivrance et une formule pour prédire le point temporel de la défaillance ;
dans lequel la formule est :

$$t = b*\ln\left(\frac{1}{\text{output}} - 1\right) + T$$

où t représente le point temporel auquel la mémoire en cours de test présente la défaillance, b est un second coefficient prédéfini, output est le résultat de délivrance, et T est une durée d'influence de défaillance prédéfinie.

Start

Acquire multiple types of log data of a memory under test
101

Perform feature engineering construction according to the multiple types of log data, to obtain respective feature data tables corresponding to the multiple types of log data
102

Splice the respective feature data tables corresponding to the multiple types of log data, to obtain a spliced feature data table
103

Obtain a failure prediction result of the memory under test according to the spliced feature data table and a pre-trained failure prediction model
104

End

FIG. 1

FIG.2

FIG.3

1021

Pre-process multiple types of log data

1022

Data check

1023

Perform feature engineering construction according to the checked multiple types of log data, respectively

FIG.4

FIG. 5

601

Label samples in a training data set to obtain a label value of each sample

602

Perform model training with each sample labeled with a label value, to obtain a failure prediction model

603

Assess the failure prediction model

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 113297046 A
- US 2015074469 A1